# EUROPEAN PATENT APPLICATION

(11) **EP 2 666 554 A1**
(43) Date of publication of application: **27.11.2013**
(21) Application number: 13168559.6
(22) Date of filing: 21.05.2013
(51) Int. Cl.: B08B 3/12

(54) **Ultrasonic cleaning method and ultrasonic cleaning apparatus**

(30) Priority: 24.05.2012 JP 2012118636
(71) Applicant: Siltronic AG, 81737 München (DE)
(72) Inventor: Uchibe, Masashi, Izumo, Shimane 693-0062 (JP); Mori, Yoshihiro, Nakagyo-ku, Kyoto 604-8457 (JP); Haibara, Teruo, Hikari, Yamaguchi 743-0011 (JP); Kubo, Etsuko, Yokkaichi, Mie 512-1306 (JP)
(74) Representative: Baar, Christian

(57) **Abstract**

Subject: There is provided an ultrasonic cleaning method and an ultrasonic cleaning apparatus by which a high particle removal rate is obtained in a stable manner.

Means for solving the problem: An ultrasonic cleaning method for cleaning an object to be cleaned in a liquid in which a gas is dissolved, by irradiating the liquid with ultrasonic waves, the method comprising the following steps: The liquid in which the gas is dissolved is prepared (S10). The object to be cleaned is cleaned while ultrasonic waves are applied to the liquid so that a region where a spatial rate of change of a refractive index of the liquid in which the gas is dissolved is large relative to a case where ultrasonic waves are not applied appears along a direction in which the ultrasonic waves travel (S40) .

## Description

### Technical Field

The present invention relates to an ultrasonic cleaning method and an ultrasonic cleaning apparatus, and particularly to an ultrasonic cleaning method and an ultrasonic cleaning apparatus for cleaning an object to be cleaned in a liquid in which a gas is dissolved, by irradiating the liquid with ultrasonic waves.

### Background Art

In a process of manufacturing a substrate such as a silicon wafer, a substrate cleaning process of an immersion type, a single wafer type or the like has been conventionally conducted in order to remove, from the substrate, organic substances, metallic impurities, particles, natural oxide films and the like that cause a defect in a semiconductor device.

In the substrate cleaning process, various types of cleaning methods have been used depending on its purpose. Particularly when the immersion-type cleaning method is used to remove foreign substances such as particles, use is made of a method for immersing the substrate in a cleaning liquid contained in a cleaning tank and irradiating the cleaning liquid in which the substrate is immersed with ultrasonic waves having a frequency of around 1 MHz, which is called megasonic. It is generally believed that when the ultrasonic waves having a frequency of around 1 MHz are used, damage to the substrate can be reduced and the cleaning effect on submicron-size fine particles on the substrate surface can be increased.

It has been known that a concentration of a dissolved gas in the cleaning liquid affects the efficiency of removal of the foreign substances such as particles. It has been found that when ultrapure water is used as the cleaning liquid and the ultrapure water is irradiated with megasonic to remove the particles from the substrate, for example, a rate of removal of the particles from the substrate is affected by a dissolved nitrogen concentration in the cleaning liquid. More specifically, when the dissolved gas concentration in the cleaning liquid is within a prescribed range, the rate of removal of the particles from the substrate is relatively high (Japanese Patent Laying-Open Nos. JP10-109072A and JP2007-250726A). Therefore, by monitoring the dissolved gas concentration such as the dissolved nitrogen concentration in the cleaning liquid and controlling the dissolved gas concentration in the cleaning liquid to fall within a certain range in the cleaning process, it becomes theoretically possible to remove the particles effectively.

On the other hand, there is a report that the behavior of removal of the particles from the substrate is somehow related to the behavior of weak light emission (sonoluminescence) that occurs when the cleaning liquid is irradiated with the ultrasonic waves ("Behaviour of a Well Designed Megasonic Cleaning System", Solid State Phenomena Vols.103-104 (2005) pp.155-158; "Megasonics: A cavitation driven process", Solid State Phenomena Vols.103-104 (2005) pp.159-162).

### Problems to be Solved by the Invention

As a result of studies on ultrasonic cleaning of a substrate that have been conducted in the past by the inventors, it has turned out that a particle removal rate may be high or low even under the same dissolved gas concentration and the same ultrasonic irradiation conditions. Therefore, it has been difficult to realize a state having a high particle removal rate in a stable manner, simply by adjusting the dissolved gas concentration and the ultrasonic irradiation conditions.

The present invention has been made in light of the aforementioned problem, and an object of the present invention is to provide an ultrasonic cleaning method and an ultrasonic cleaning apparatus by which a high particle removal rate is obtained in a stable manner.

### Means for Solving the Problems

The inventors have earnestly studied a relationship between the refractive index of the liquid and the particle removal rate, and as a result, have obtained the following findings. Specifically, the inventors of the present invention have found that the particle removal rate of the liquid can be increased by cleaning an object to be cleaned while irradiating the liquid with ultrasonic waves so that a region, where a spatial rate of change of the refractive index of the liquid is large relative to a case where ultrasonic waves are not applied, appears along a direction in which the ultrasonic waves travel. Accordingly, the inventors of the present invention have arrived at the present invention.

An ultrasonic cleaning method according to the present invention is an ultrasonic cleaning method for cleaning an object to be cleaned in a liquid in which a gas is dissolved, by irradiating the liquid with ultrasonic waves, and the method includes the following steps. The liquid in which the gas is dissolved is prepared. An object to be cleaned is cleaned while the liquid is irradiated with ultrasonic waves so that a region, where a spatial rate of change of the refractive index of the liquid in which the gas is dissolved is large relative to a case where ultrasonic waves are not applied, appears along the direction in which the ultrasonic waves travel. Accordingly, a high particle removal rate can be obtained in a stable manner.

Preferably, the ultrasonic cleaning method has the step of measuring the spatial rate of change of the refractive index of the liquid. The spatial rate of change of the refractive index of the liquid can be measured to confirm the state of the liquid.

Preferably, in the ultrasonic cleaning method, the step of measuring the spatial rate of change of the refractive index of the liquid includes the step of observing transmitted light having passed through the liquid while applying parallel rays to the liquid, in a state where the ultrasonic waves are applied to the liquid. The transmitted light can be measured to confirm the state of the liquid.

Preferably, in the ultrasonic cleaning method, the step of measuring the spatial rate of change of the refractive index of the liquid includes the step of observing first transmitted light which is transmitted through the liquid while applying parallel rays to the liquid, in a state where ultrasonic waves are applied to the liquid, and the step of observing second transmitted light which is transmitted through the liquid while applying parallel rays to the liquid, in a state where ultrasonic waves are not applied to the liquid, and the step of comparing the brightness of the first transmitted light and the brightness of the second transmitted light. The brightness of the first transmitted light and that of the second transmitted light can be compared with each other to confirm the state of the liquid.

Preferably, in the step of cleaning the object to be cleaned of the ultrasonic cleaning method, the liquid is adjusted based on the spatial rate of change to realize a state where bubbles containing the gas continue to be generated in the liquid. Accordingly, the liquid having a high particle removal rate in a stable manner can efficiently be adjusted.

Preferably, in the ultrasonic cleaning method, the step of cleaning the object to be cleaned includes the step in which sonoluminescence occurs. Accordingly, a high particle removal rate is obtained in a more stable manner.

Preferably, in the ultrasonic cleaning method, the gas is nitrogen and a dissolved gas concentration in the liquid is 5 ppm or more.

An ultrasonic cleaning apparatus according to the present invention is an ultrasonic cleaning apparatus for cleaning an object to be cleaned in a liquid in which a gas is dissolved, by irradiating the liquid with ultrasonic waves, and the apparatus includes irradiation means, a container, and a device. The irradiation means is capable of applying ultrasonic waves to the liquid. The container is capable of containing the liquid. The device is capable of measuring a spatial rate of change of a refractive index of the liquid.

The ultrasonic cleaning apparatus of the present invention has the device capable of measuring the spatial rate of change of the refractive index of the liquid. Accordingly, the state of the liquid can be confirmed.

Preferably, the ultrasonic cleaning apparatus has an adjusting mechanism capable of realizing a state where bubbles containing the gas continue to be generated in the liquid. Accordingly, the liquid having a high particle removal rate in a stable manner can efficiently be adjusted.

### Effects of the Invention

According to the present invention, there can be provided an ultrasonic cleaning method and an ultrasonic cleaning apparatus by which a high particle removal rate is obtained in a stable manner.

### Brief Description of the Drawings

Fig. 1 is a schematic diagram showing an ultrasonic cleaning apparatus according to one embodiment of the present invention.
Fig. 2 shows one example of an apparatus configuration when sonoluminescence is observed.
Fig. 3 shows an example of a configuration of a device capable of measuring the spatial rate of change of the refractive index of a liquid.
Fig. 4 is a schematic diagram of an image obtained by observing transmitted light having passed through a liquid in accordance with the Schlieren method.
Fig. 5 is a schematic diagram showing a relationship between the dissolved nitrogen concentration and the presence or absence of foggy bubbles.
Fig. 6 is a flowchart showing an ultrasonic cleaning method according to one embodiment of the present invention.
Fig. 7 is a diagram showing a relationship between the dissolved gas concentration and time, regarding the ultrasonic cleaning method according to one embodiment of the present invention.
Fig. 8 is a diagram showing a relationship between the dissolved gas concentration and time, regarding the ultrasonic cleaning method according to one embodiment of the present invention.

**Description of the Reference Characters**

| | |
|---|---|
| 10 | supply means |
| 11 | first supply valve |
| 12 | second supply valve |
| 20 | cleaning tank |
| 21 | indirect water tank |
| 22 | holding portion |
| 23 | liquid introducing pipe |
| 30 | irradiation means |
| 40 | monitoring means |
| 41 | extraction pipe |
| 42 | pump |
| 43 | dissolved nitrogen concentration meter |
| 50 | dark room |
| 60 | light emission detecting apparatus |
| 61 | image processing apparatus |
| 71 | device for measuring the spatial change of the refractive index of the liquid |
| 80 | light source unit |
| 81 | knife edge unit |
| 82 | light source |
| 83, 84 | condenser lens |
| 85 | slit |
| 86, 89 | plane mirror |
| 87, 88 | concave mirror |
| 90 | knife edge |
| 91 | telephoto lens |
| 92 | camera |
| 93 | incident light |
| 94 | transmitted light |
| 100 | ultrasonic cleaning apparatus |
| W | wafer |

### Best Modes for Carrying Out the Invention

An embodiment of the present invention will be described hereinafter with reference to the drawings, in which the same reference characters are given to the same or corresponding portions and description thereof will not be repeated.

First, a configuration of an ultrasonic cleaning apparatus according to one embodiment of the present invention will be described.

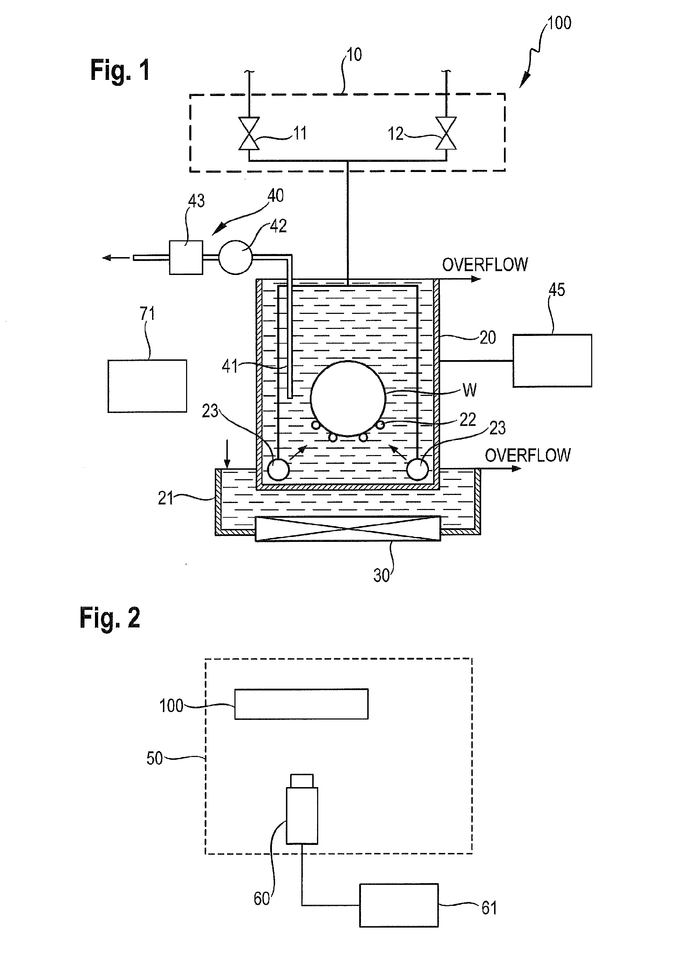

As shown in Fig. 1, an ultrasonic cleaning apparatus 100 according to the present embodiment has: a cleaning tank 20 containing therein a cleaning liquid such as ultrapure water; supply means 10 for supplying the cleaning liquid to this cleaning tank 20; an indirect water tank 21 storing cleaning tank 20; irradiation means 30 arranged at the bottom of indirect water tank 21 and capable of applying ultrasonic waves; monitoring means 40 for monitoring a dissolved nitrogen concentration in the cleaning liquid supplied into cleaning tank 20; and a device 71 capable of measuring the spatial rate of change of the refractive index of the liquid. Supply means 10 has a first supply valve 11 for supplying ultrapure water in which a nitrogen gas is dissolved to cleaning tank 20, and a second supply valve 12 for supplying degassed ultrapure water to cleaning tank 20.

First supply valve 11 is connected to a not-shown first tank. The ultrapure water in which the nitrogen gas is dissolved is stored in the first tank. Second supply valve 12 is connected to a not-shown degassed water manufacturing apparatus. Ultrapure water is supplied to the degassed water manufacturing apparatus, where a dissolved gas in the ultrapure water can be removed through a degassing membrane. The ultrapure water in which the nitrogen gas is dissolved and the degassed ultrapure water are mixed because pipes connected to first supply valve 11 and second supply valve 12 merge into one pipe on the downstream side of first supply valve 11 and second supply valve 12. A mixing tank (not shown) may be arranged on the downstream side of first supply valve 11 and second supply valve 12. In this case, the ultrapure water in which the nitrogen gas is dissolved and the degassed ultrapure water can be completely mixed in this mixing tank.

The mixed ultrapure water is then supplied to a liquid introducing pipe 23 through a pipe connected to the downstream side of aforementioned first supply valve 11 and second supply valve 12 and disposed within cleaning tank 20. Liquid introducing pipe 23 is disposed near an outer circumferential end of the bottom surface of cleaning tank 20. By adjusting the degree of opening of first supply valve 11 and second supply valve 12, the dissolved nitrogen concentration in the ultrapure water introduced into cleaning tank 20 as well as an amount of supply thereof can be controlled.

Liquid introducing pipe 23 is provided with a plurality of not-shown nozzles. Through these nozzles, the ultrapure water, which is the cleaning liquid, is supplied from liquid introducing pipe 23 into cleaning tank 20. The plurality of nozzles are spaced apart from one another along the direction in which liquid introducing pipe 23 extends. These nozzles are arranged so as to inject the cleaning liquid toward almost the central portion of cleaning tank 20 (region where a wafer W, which is an object to be cleaned, is held).

Cleaning tank 20 is a container capable of containing the cleaning liquid and a holding portion 22 for holding wafer W is disposed within cleaning tank 20. For example, the wafer W is a semiconductor wafer. With wafer W being held by holding portion 22 in cleaning tank 20, the cleaning liquid constituted by the aforementioned mixed ultrapure water is supplied from liquid introducing pipe 23 into cleaning tank 20.

As described above, liquid introducing pipe 23 is disposed at the lower part of cleaning tank 20 (near the bottom wall or in a region located at the outer circumferential portion of the bottom wall that connects the bottom wall and the sidewall). A prescribed amount of the cleaning liquid (mixed ultrapure water) is supplied from liquid introducing pipe 23 into cleaning tank 20. The amount of supply of the cleaning liquid is adjusted such that cleaning tank 20 is filled with the cleaning liquid and a prescribed amount of the cleaning liquid overflows from the upper part of cleaning tank 20. As a result, wafer W is immersed in the cleaning liquid in cleaning tank 20 as shown in Fig. 1.

A supply line (not shown) for a medium different from the medium supplied by aforementioned supply means 10 is connected to indirect water tank 21. Water serving as the medium is supplied from this supply line into indirect water tank 21. At least the bottom wall of aforementioned cleaning tank 20 is in contact with the water stored in indirect water tank 21. A prescribed amount of the water continues to be supplied from the supply line to indirect water tank 21, and thereby a certain amount of the water overflows from indirect water tank 21.

Irradiation means 30 is arranged to be connected to the bottom wall of indirect water tank 21. Irradiation means 30 irradiates the water in indirect water tank 21 with ultrasonic waves. The applied ultrasonic waves are applied through the water in indirect water tank 21 and a portion of cleaning tank 20 that is in contact with the water (e.g., the bottom wall) to the cleaning liquid and wafer W in cleaning tank 20.

Irradiation means 30 can generate ultrasonic waves having a frequency of 20 kHz or more and 2 MHz or less and a watt density of 0.05 W/cm² or more and 7.0 W/cm² or less, for example. Since the cleaning liquid and wafer W are irradiated with the ultrasonic waves in such a manner, wafer W immersed in the cleaning liquid can be efficiently cleaned. Ultrasonic waves having a frequency range of 400 kHz or more and 1 MHz or less are preferably used as the ultrasonic waves applied by irradiation means 30.

Monitoring means 40 includes: an extraction pipe 41 extracting a prescribed amount of the cleaning liquid from inside cleaning tank 20; a pump 42 connected to extraction pipe 41, for introducing the cleaning liquid to a dissolved nitrogen concentration meter 43; and dissolved nitrogen concentration meter 43 connected to the downstream side of pump 42. Data of the measured dissolved nitrogen concentration in the cleaning liquid is output from dissolved nitrogen concentration meter 43 to a display unit included in dissolved nitrogen concentration meter 43. An apparatus having an arbitrary configuration can be used as dissolved nitrogen concentration meter 43. For example, a measuring apparatus can be used, in which a dissolved gas component contained in the cleaning liquid is introduced into a receptor through a polymer film and a concentration of the gas component is calculated based on a change in thermal conductivity in this receptor.

Cleaning tank 20 is made of, for example, quartz glass having a thickness of 3.0 mm. Cleaning tank 20 can have an arbitrary shape. For example, a square water tank having a width of 270 mm, a depth of 69 mm and a height of 270 mm in terms of inside dimension is used as cleaning tank 20. A cleaning tank 20 with these dimensions has a capacity of 5 liters.

The thickness of the quartz glass plate material forming the bottom wall of cleaning tank 20 is preferably adjusted as appropriate, depending on the frequency of the ultrasonic waves emitted from irradiation means 30. For example, when the frequency of the ultrasonic waves emitted from irradiation means 30 is 950 kHz, the thickness of the plate material forming the bottom wall is preferably 3.0 mm. When the frequency of the ultrasonic waves emitted from irradiation means 30 is 750 kHz, the thickness of the plate material forming the bottom wall is preferably 4.0 mm, for example.
[0036] The amount of the cleaning liquid (mixed ultrapure water) supplied from supply means 10 to cleaning tank 20 may be 5 liters/min. The frequency of the ultrasonic waves applied by irradiation means 30 may be 950 kHz and 750 kHz as described above, and the output thereof may be 1200 W (watt density of 5.6 W/cm²). A radiation surface of a vibrating plate in irradiation means 30 may have a size of 80 mm x 270 mm.

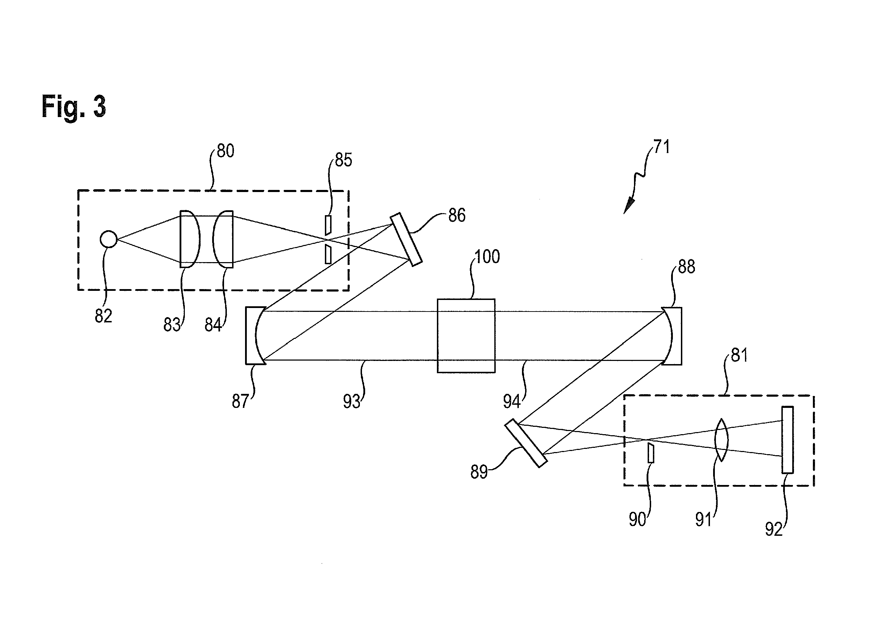

Device 71 capable of measuring the spatial change of the refractive index of the liquid is for example a concave-mirror-type Schlieren apparatus. Referring to Fig. 3, the concave-mirror-type Schlieren apparatus basically includes a light source unit 80, a knife edge unit 81, plane mirrors 86, 89, and concave mirrors 87, 88. Light source unit 80 includes a light source 82, condenser lenses 83, 84, and a slit 85. Knife edge unit 81 has a knife edge 90, a telephoto lens 91, and a camera 92.

Light source 82 is a point light source and is for example a xenon lamp or the like. The light from light source 82 is collected by condenser lenses 83, 84 and passes through slit 85. The light having passed through slit 85 is reflected by plane mirror 86 and incident on concave mirror 87 to be reflected therefrom. The light reflected by concave mirror 87 becomes parallel rays. Incident light 93 which has become the parallel rays enters the liquid stored in cleaning tank 20 of ultrasonic cleaning apparatus 100 which is to be measured. Transmitted light 94 which has passed through the liquid is incident on concave mirror 88 and reflected therefrom. Transmitted light 94 reflected by concave mirror 88 is reflected by plane mirror 89 to travel toward knife edge unit 81. Transmitted light 94 having passed through knife edge 90 is enlarged by telephoto lens 91 to reach camera 92. The light and shadow of transmitted light 94 which has reached camera 92 can be observed as a Schlieren image. Ultrasonic cleaning apparatus 100 may have a liquid adjusting mechanism 45. Liquid adjusting mechanism 45 refers for example to a mechanism capable of introducing a gas into a liquid. The mechanism capable of introducing a gas into a liquid has for example a bubble introducing tube (not shown). One end of the bubble introducing tube is located near the bottom surface of cleaning tank 20 and is immersed in the liquid. The other end of the bubble introducing tube is connected for example to a gas supply unit (not shown). The gas supply unit is configured to be capable of supplying a gas to the liquid through the bubble introducing tube. The opening of the one end of the bubble introducing tube has a size of approximately 5 mm, for example. The gas supply unit is capable of supplying 1 mL to 10 mL of the gas, for example.

Liquid adjusting mechanism 45 may also be a mechanism for stirring the liquid. The mechanism for stirring the liquid has for example a stirring unit (not shown). The stirring unit has a body and a blade portion. The blade portion is immersed in the liquid. One end of the body is connected for example to a drive (not shown) such as motor. The stirring unit is configured to be rotatable about the rotational axis which is the central axis of the body. Namely, the stirring unit is configured to be capable of stirring the liquid. The blade portion has a diameter on the order of 25 mm and a height on the order of 40 mm. The number of blades of the blade portion is for example six. The stirring unit is made for example of polytetrafluoroethylene (PTFE, also known under the brand name Teflon^{®}) .

Liquid adjusting mechanism 45 may further have a feedback mechanism capable of realizing a state where bubbles containing a liquid which is the dissolved gas continue to be generated in the liquid, based on the spatial rate of change of the refractive index of the liquid measured by device 71. Specifically, the feedback mechanism is a mechanism measuring, by means of camera 92 of the Schlieren apparatus shown in Fig. 3 for example, the brightness of transmitted light 94 of the liquid and, based on the brightness of this transmitted light 94, stirring the liquid or introducing the gas into the liquid. For example, the liquid is adjusted so that the brightness of transmitted light 94 is darkest.

An apparatus configuration for observing sonoluminescence (light emission phenomenon) will be described with reference to Fig. 2. First, ultrasonic cleaning apparatus 100 and a light emission detecting apparatus 60 are disposed within a dark room 50. Light emission detecting apparatus 60 is connected to an image processing apparatus 61. An image intensifier unit (extremely weak light sensing and intensifying unit) used as light emission detecting apparatus 60 is an apparatus for sensing and intensifying extremely weak light to obtain a contrast image. Specifically, a unit using an image intensifier (V4435U-03) manufactured by Hamamatsu Photonics K.K. can be used as this unit. In this unit, a photoelectric surface is made of Cs-Te, a sensitivity wavelength range is from 160 to 320 nm, and the highest sensitivity wavelength is 250 nm. It is believed that light emission when water is irradiated with ultrasonic waves is caused by hydroxy radical (OH radical) that occurs as a result of decomposition of the water, and the light emission has a wavelength in an ultraviolet region of around 309 nm. Therefore, the image intensifier unit having the photoelectric surface material (Cs-Te) and having the aforementioned wavelength as the sensitivity wavelength range is used. A photomultiplier may be used as light emission detecting apparatus 60. Conditions of the apparatus include, for example, an ultrasonic frequency, an ultrasonic intensity, a design of a water tank containing a solution, an amount of supply of the solution, and the like.

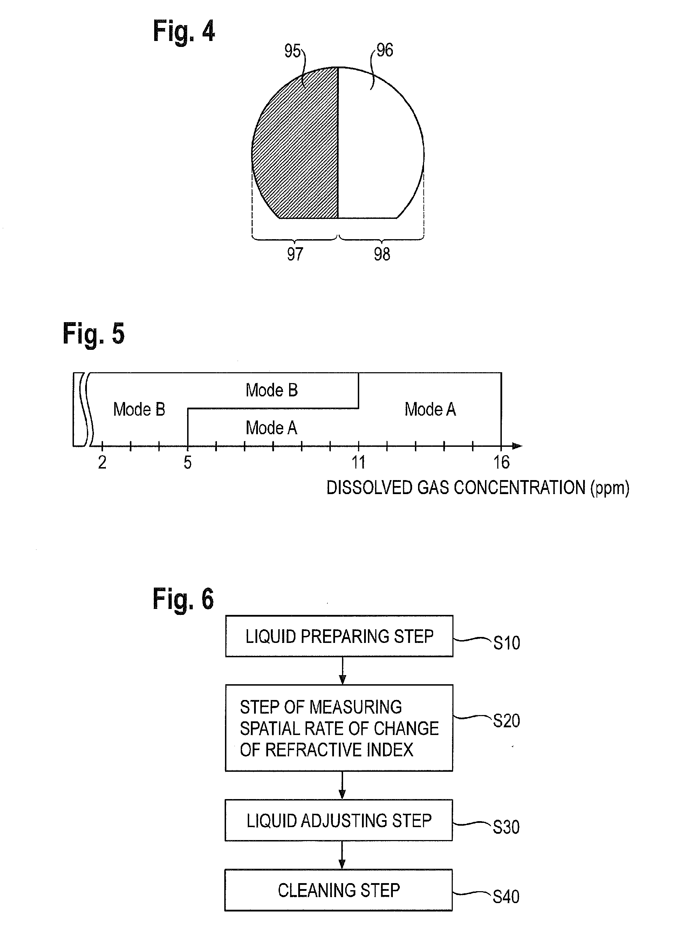

Referring to Figs. 3 and 4, a Schlieren image observed by a Schlieren apparatus will be described.

First, referring to Fig. 3, light emitted from light source unit 80 is reflected by plane mirror 86 and concave mirror 87 to become incident light 93 in the form of parallel rays. Incident light 93 passes through the liquid stored in cleaning tank 20 of ultrasonic cleaning apparatus 100. Transmitted light 94 which has passed through the liquid is reflected by concave mirror 88 and plane mirror 89 to travel toward knife edge unit 81. Knife edge 90 is disposed at the focus position where transmitted light 94 having passed through the liquid to which ultrasonic waves are not applied (namely the liquid without the spatial change of the refractive index) is converged. In other words, knife edge 90 is disposed so that transmitted light 94 having passed through the liquid without spatial change of the refractive index is not blocked while transmitted light 94 having passed through the liquid having a spatial change of the refractive index is blocked.

Fig. 4 shows a Schlieren image provided by camera 92 observing transmitted light 94 having passed through the liquid stored in the water tank that is an object to be measured. Wafer W is not immersed in the liquid. A region 97 in Fig. 4 is a region where ultrasonic waves are applied to the liquid and a region 98 in Fig. 4 is a region where ultrasonic waves are not applied to the liquid. In region 98 where ultrasonic waves are not applied to the liquid, transmitted light 94 is bright. Namely, there is a small quantity of transmitted light 94 blocked by knife edge 90. In contrast, in region 97 where ultrasonic waves are applied to the liquid, transmitted light 94 is dark. Namely, there is a large quantity of transmitted light 94 blocked by knife edge 90. Transmitted light 94 does not necessarily become dark when ultrasonic waves are applied to the liquid. The brightness of transmitted light 94 is considered as varying depending on the state of the liquid.

When a spatial change occurs to the refractive index of the liquid stored in cleaning tank 20 of ultrasonic cleaning apparatus 100, the direction of travel of transmitted light 94 changes. Thus, transmitted light 94 is blocked by knife edge 90, and therefore, the light arriving at camera 92 is weak and transmitted light 94 is observed as being dark. Namely, the brightness of transmitted light 94 can be observed to thereby observe the spatial change of the refractive index of the liquid.

Next, an ultrasonic cleaning method according to the present embodiment will be described.

The ultrasonic cleaning method according to the present embodiment will be described with reference to Fig. 6. The ultrasonic cleaning method according to the present embodiment is a method for cleaning wafer W (object to be cleaned) immersed in a liquid in which a gas such as nitrogen is dissolved, by irradiating the liquid with ultrasonic waves, and the method mainly includes the following steps.

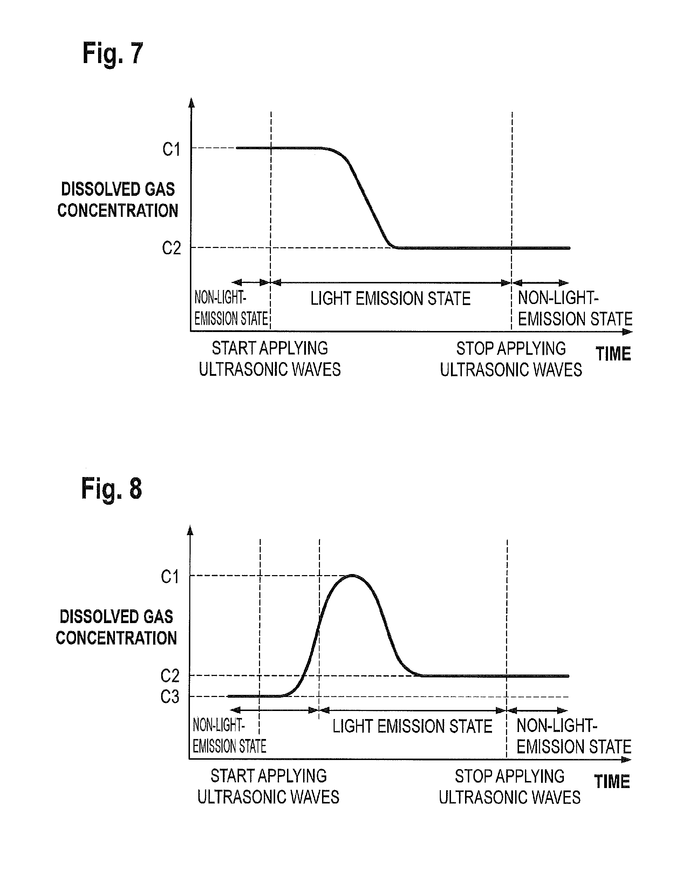

First, a liquid preparing step (S10) is performed. For example, using the cleaning apparatus shown in Fig. 1, ultrapure water in which a nitrogen gas is dissolved and degassed ultrapure water are mixed, and a liquid (cleaning liquid) having a first dissolved gas concentration (C1: see Fig. 7) is prepared. The dissolved nitrogen concentration of the liquid is preferably 5 ppm or more.

Next, the step of measuring the spatial rate of change of the refractive index of the liquid (S20) is performed. Specifically, the Schlieren apparatus shown in Fig. 3 is used to measure the spatial rate of change of the refractive index of the liquid.

Referring to Fig. 3, an example of measurement of the spatial rate of change of the refractive index of the liquid will be described. First, to the liquid to which ultrasonic waves are not applied, incident light 93 in the form of parallel rays is applied. Transmitted light 94 having passed through the liquid (first transmitted light) is observed by camera 92.

Next, to the liquid to which ultrasonic waves are applied, incident light 93 in the form of parallel rays is applied. Transmitted light 94 having passed through the liquid (second transmitted light) is observed by camera 92. Transmitted light 94 may partially be blocked when passing through knife edge 90.

Subsequently, the brightness of the first transmitted light and the brightness of the second transmitted light are compared with each other. The comparison of the brightness is made by quantifying the brightness for example and comparing resultant values of the brightness with each other. The brightness can be quantified using the luminous intensity or illumination for example.

While the method of observing the spatial change of the refractive index of the liquid by means of the Schlieren method has been described in connection with the present embodiment, the method is not limited to this form. For example, the shadowgraph method may be used to observe the spatial change of the refractive index of the liquid.

Next, a liquid adjusting step (S30) is performed. Specifically, in the liquid adjusting step, a gas is introduced into the liquid while the liquid is irradiated with ultrasonic waves. For example, the gas is introduced into the liquid from the outside using a bubble introducing tube, and thereby bubbles are generated in the liquid. Although the gas introduced into the liquid is, for example, nitrogen, the gas is not limited thereto. The gas introduced into the liquid may be, for example, argon (Ar), helium (He), air or the like. From the viewpoint of generating the bubbles in the liquid, it is desirable to use a gas having a low degree of solubility in water, which is the liquid.

The gas introduced into the liquid has a volume of, for example, 10 mL. Preferably, the gas introduced into the liquid has a volume of 1 mL or more. The pressure of the gas may be any pressure as long as it overcomes the pressure of the liquid and allows formation of the bubbles.

In the liquid adjusting step (S30), the liquid may also be stirred while the liquid is irradiated with the ultrasonic waves, for example. Preferably, the stirring unit may be driven in the liquid to cause bubbles of the gas dissolved in the liquid to be generated. Specifically, the stirring unit immersed in the liquid is rotated by a motor for example to thereby stir the liquid. The number of revolutions of the stirring unit is for example 1400 rpm (revolutions per minute). Preferably, the number of revolutions of the stirring unit is 1400 rpm or more. Stirring the liquid includes agitating the liquid. For example, the stirring unit may be moved to and fro vertically or laterally to stir the liquid.

In the liquid adjusting step (S30), with reference to Fig. 7 for example, the step of changing the dissolved gas concentration from a first dissolved gas concentration (C1) to a second dissolved gas concentration (C2) may further be performed. The dissolved gas concentration can be changed for example by adjusting the first supply valve 11 of ultrasonic cleaning apparatus 100 shown in Fig. 1 to thereby reduce the amount of supplied ultrapure water in which nitrogen gas is dissolved. The dissolved gas concentration can also be changed by adjusting the second supply valve 12 of ultrasonic cleaning apparatus 100 to thereby increase the amount of supplied ultrapure water in which nitrogen gas is not dissolved. Moreover, both the first supply valve 11 and the second supply valve 12 can be adjusted to adjust the dissolved gas concentration of the liquid. While the dissolved gas concentration in the liquid changes from the first dissolved gas concentration (C1) to the second dissolved gas concentration (C2), the liquid is continuously irradiated with ultrasonic waves. While the liquid is irradiated with ultrasonic waves, a state where sonoluminescence occurs may continue.

Here, how to determine the first dissolved gas concentration (C1) and the second dissolved gas concentration (C2) will be described. For example, cleaning liquids having respective dissolved gas concentrations different from each other are prepared, and wafer W to be cleaned is immersed in the cleaning liquids. After this, under the same conditions except for the dissolved gas concentration of the cleaning liquid, the cleaning liquids are irradiated with ultrasonic waves to clean wafer W. The dissolved gas concentration of the cleaning liquid providing a highest cleaning efficiency is defined as an optimum dissolved gas concentration and it is determined that this concentration is the second dissolved gas concentration. Since wafer W is cleaned finally in the liquid having the second dissolved gas concentration, the second dissolved gas concentration is preferably a concentration close to an optimum dissolved gas concentration. The second dissolved gas concentration, however, may not be an optimum dissolved gas concentration as long as the second dissolved gas concentration causes sonoluminescence to occur. The first dissolved gas concentration is defined as a concentration higher than the second dissolved gas concentration.

In the liquid adjusting step (S30), with reference to Fig. 8 for example, the step of changing the dissolved gas concentration from a third dissolved gas concentration (C3) to the first dissolved gas concentration (C1) may further be performed. The third dissolved gas concentration is a concentration lower than the above-described first dissolved gas concentration. The third dissolved gas concentration may be substantially equal to the above-described second dissolved gas concentration. The third dissolved gas concentration may be higher or lower than the second dissolved gas concentration. The dissolved gas concentration is changed for example by supplying a liquid having a high dissolved gas concentration to cleaning tank 20 in which wafer W is contained. While the dissolved gas concentration of the liquid changes from the third dissolved gas concentration (C3) to the first dissolved gas concentration (C1), ultrasonic waves are continuously applied to the liquid. At the time when the dissolved gas concentration of the liquid is the third dissolved gas concentration (C3), sonoluminescence has not occurred and this is non-light-emission state. While the third dissolved gas concentration (C3) changes to the first dissolved gas concentration (C1), sonoluminescence occurs and a light emission state is reached.

Then, the step of changing the dissolved gas concentration from the first dissolved gas concentration (C1) to the second dissolved gas concentration (C2) is performed. While the dissolved gas concentration in the liquid is changing from the first dissolved gas concentration (C1) to the second dissolved gas concentration (C2), the liquid is continuously irradiated with ultrasonic waves. While the liquid is irradiated with ultrasonic waves, the state where sonoluminescence occurs may continue.

In the liquid adjusting step (S30), the step of measuring the spatial rate of change of the refractive index of the liquid (S20) may be continued. Specifically, while the dissolved gas concentration of the liquid is changed, the spatial rate of change of the refractive index may be measured.

Preferably, in the liquid adjusting step (S30), based on the spatial rate of change of the refractive index of the liquid that is measured in the step of measuring the spatial rate of change of the refractive index of the liquid (S20), the liquid is adjusted so that a state where bubbles containing nitrogen continue to be generated in the liquid is realized. Specifically, the dissolved gas concentration of the liquid is adjusted by liquid adjusting mechanism 45 so that a region where the spatial rate of change of the refractive index of the liquid is large as compared with the case where ultrasonic waves are not applied appears along the direction in which the ultrasonic waves travel. Still more specifically, the Schlieren apparatus shown in Fig. 3 is used to adjust the dissolved gas concentration of the liquid so that the brightness of transmitted light 94 having passed through knife edge 90 that is observed by camera 92 is darker than that in the case where ultrasonic waves are not applied. The liquid may also be adjusted so that the dark portion and the bright portion of transmitted light 94 observed by camera 92 alternately appear along the direction in which the ultrasonic waves travel (top-bottom direction in Fig. 1).

In the present embodiment, after the liquid adjusting step (S30) is performed, foggy bubbles are generated in the liquid. The foggy bubbles are bubbles containing the gas (nitrogen in the present embodiment) dissolved in the liquid. Thus, the state where the bubbles containing nitrogen continue to be generated is realized.

In the liquid preparing step (S10), a liquid in which bubbles containing nitrogen continue to be generated may be prepared directly. In this case, the liquid adjusting step (S30) can be skipped.

In the ultrasonic cleaning method according to the present embodiment, sonoluminescence occurs after the liquid adjusting step (S30). Sonoluminescence can be sensed by an image intensifier or photomultiplier as shown in Fig. 2. In the liquid adjusting step (S30), it is enough to enable the state where bubbles containing nitrogen continue to be generated in the liquid to be realized, and sonoluminescence may not occur in the liquid.

Next, a cleaning step (S40) is performed. In the cleaning step, wafer W, which is the object to be cleaned, is cleaned in the state where the bubbles containing nitrogen continue to be generated. In the cleaning step, wafer W, which is an object to be cleaned, is cleaned in such a manner that a region where the spatial rate of change of the refractive index of the liquid in which the gas is dissolved is large, relative to the case where ultrasonic waves are not applied, appears along the direction in which the ultrasonic waves travel. It is preferable that sonoluminescence is occurring in the cleaning step.

A description will now be given of a hypothesis about a mechanism by which a high particle removal rate is obtained in a stable manner when an object to be cleaned is cleaned in such a manner that a region where the spatial rate of change of the refractive index of the liquid is large as compared with the case where ultrasonic waves are not applied appears along the direction in which the ultrasonic waves travel.

The mechanism by which particles are removed by ultrasonic waves in the liquid is considered as being related to the cavitation phenomenon. The cavitation phenomenon is considered as a phenomenon in which bubbles continue to be generated by pressure variations (density variations) in a minute area of the liquid. Particles are considered as being efficiently removed when the cavitation phenomenon efficiently occurs in the liquid.

It is also considered that, in the case where the cavitation phenomenon efficiently occurs, the spatial change of the refractive index is caused to occur by the density variations of the liquid and the spatial change of the refractive index is observed for example by the Schlieren apparatus. The spatial rate of change of the refractive index can be observed using the brightness of transmitted light 94 of the liquid. Namely, while the brightness of transmitted light 94 is observed for example, the spatial rate of change of the refractive index can be adjusted to thereby realize the state where a high particle removal rate is obtained in a stable manner.

Next, the functions and effects of the present embodiment will be described.

According to the ultrasonic cleaning method of the present embodiment, an object to be cleaned is cleaned while ultrasonic waves are applied to the liquid, so that a region where the spatial rate of change of the refractive index of the liquid in which the gas is dissolved is large relative to the case where ultrasonic waves are not applied, appears along the direction in which the ultrasonic waves travel. Accordingly, a high particle removal rate can be obtained in a stable manner.

According to the ultrasonic cleaning method of the present embodiment, the step of measuring the spatial rate of change of the refractive index of the liquid includes the step of observing first transmitted light which is transmitted through the liquid while applying parallel rays to the liquid, in a state where ultrasonic waves are applied to the liquid, and the step of observing second transmitted light which is transmitted through the liquid while applying parallel rays to the liquid, in a state where ultrasonic waves are not applied to the liquid, and the step of comparing brightness of the first transmitted light and brightness of the second transmitted light. Accordingly, the state of the liquid can be confirmed.

According to the ultrasonic cleaning method of the present embodiment, in the step of cleaning the object to be cleaned, the liquid is adjusted based on the spatial rate of change so that a state where bubbles containing the gas continue to be generated in the liquid is realized. Accordingly, the liquid having a high particle removal rate in a stable manner can efficiently be adjusted.

Ultrasonic cleaning apparatus 100 of the present embodiment has a device capable of measuring the spatial rate of change of the refractive index of the liquid. The state of the liquid can thus be confirmed.

Ultrasonic cleaning apparatus 100 of the present embodiment also has an adjusting mechanism capable of realizing a state where bubbles containing the gas continue to be generated in the liquid. Accordingly, the liquid having a high particle removal rate in a stable manner can efficiently be adjusted.

### Example 1

An object of the experiment here is to verify a difference in the rate of removal of particles attached to wafer W between the cleaning method according to the present invention and a cleaning method according to a comparative example that are used to clean wafer W.

First, a cleaning apparatus used in this experiment will be described with reference to Fig. 1. The square water tank made of quartz glass having a thickness of 3.0 mm was used as cleaning tank 20 in the experiment. The water tank had a width of 270 mm, a depth of 69 mm and a height of 285 mm in terms of inside dimension. The plate material forming the bottom wall had a thickness of 4.0 mm. Cleaning tank 20 had a capacity of 5 liters.

The amount of the cleaning liquid (mixed ultrapure water) supplied from supply means 10 to cleaning tank 20 was set to 5 liters/min. The frequency of the ultrasonic waves applied by irradiation means 30 was set to 750 kHz and the output thereof was set to 1200 W (watt density of 5.6 W/cm²). The radiation surface of the vibrating plate in irradiation means 30 had a size of 80 mm x 270 mm. The ultrasonic waves emitted from irradiation means 30 were applied onto the entire bottom surface of cleaning tank 20.

First supply valve 11 adjusting the amount of supply of the ultrapure water in which the nitrogen gas was dissolved and second supply valve 12 adjusting the amount of supply of the degassed water were controlled, and thereby the ultrapure water in which nitrogen was dissolved was supplied to cleaning tank 20 at 5 liters/min. The ultrapure water in the water tank was sampled and the dissolved nitrogen concentration was measured by monitoring means 40.

Next, an object to be cleaned that is used to measure the particle removal rate will be described.

A P-type silicon wafer having a diameter of 200 mm was used as the object to be cleaned. Silicon dioxide particles were attached to a mirror surface of the P-type silicon wafer by spin coating. The amount of attached particles was 2000 to 3000 particles in the case of the particles of 110 nm or more.

Next, a method for measuring the particle removal rate will be described.

The wafer having the silicon dioxide particles attached thereto was immersed in the water tank and cleaned for 10 minutes. Thereafter, the wafer was dried for 2 minutes by a spin dryer. The particle removal rate is obtained as a value acquired by dividing the number of particles that decrease after cleaning by the number of particles attached to the wafer before cleaning, and this value is expressed in percentage. LS6500 manufactured by Hitachi High-Technologies Corporation was used to measure the amount of attached particles.

### Example according to the Present Invention

The cleaning method according to an example of the present invention will be described. First, a cleaning liquid whose dissolved nitrogen concentration was adjusted to 15 ppm was prepared. Next, ultrasonic waves were applied from irradiation means 30 to the cleaning liquid in which the dissolved nitrogen concentration was 15 ppm. The frequency of the applied ultrasonic waves was set to 750 kHz and the output thereof was set to 1200 W. While ultrasonic waves were applied to the cleaning liquid, the dissolved nitrogen concentration was changed from 15 ppm to 6 ppm. While the dissolved nitrogen concentration was changed, foggy bubbles were generated in the cleaning liquid. At this time, transmitted light 94 having passed through the liquid was observed by the Schlieren apparatus, and it was confirmed that a portion, which was darker than transmitted light 94 observed in the case where ultrasonic waves were not applied, appeared along the direction in which the ultrasonic waves travelled. Wafer W having silicon dioxide particles attached thereto, which was the object to be cleaned, was immersed in the liquid having the foggy bubbles, and wafer W was cleaned for 10 minutes, and thereafter, wafer W was dried for 2 minutes by a spin dryer.

### Comparative Example

Next, the cleaning method according to the comparative example will be described. First, a cleaning liquid whose dissolved nitrogen concentration was adjusted to 1.8 ppm was prepared. Next, ultrasonic waves were applied from irradiation means 30 to the cleaning liquid in which the dissolved nitrogen concentration was 1.8 ppm. The frequency of the applied ultrasonic waves was set to 750 kHz and the output thereof was set to 1200 W. While ultrasonic waves were applied to the cleaning liquid, the dissolved nitrogen concentration was changed from 1.8 ppm to 6 ppm. At this time, transmitted light 94 having passed through the liquid was observed by the Schlieren apparatus, and it was confirmed that a portion, which was darker than transmitted light 94 observed in the case where ultrasonic waves were not applied, failed to appear along the direction in which the ultrasonic waves travelled. Wafer W having silicon dioxide particles attached thereto, which was the object to be cleaned, was immersed in the liquid, and wafer W was cleaned for 10 minutes, and thereafter, wafer W was dried for 2 minutes by a spin dryer.

### Particle Removal Rate

Next, the result of the particle removal rate will be described. The particle removal rate obtained by the cleaning method of the comparative example was 18.8 %. In contrast, the particle removal rate obtained by the cleaning method of the example of the present invention was 30.5 %. It has been confirmed from this experiment that a high particle removal rate is obtained by cleaning wafer W while applying ultrasonic waves to the cleaning liquid so that a portion, which is darker than transmitted light 94 observed in the case where ultrasonic waves are not applied (namely a region where the spatial rate of change of the refractive index of the cleaning liquid is large), appears along the direction in which the ultrasonic waves travel.

### Example 2

An object of the experiment here is to examine a range of the dissolved nitrogen concentration for generating the foggy bubbles in the cleaning liquid.

First, seven different cleaning liquids having respective dissolved nitrogen concentrations of 1.9 ppm, 4.9 ppm, 6.0 ppm, 7.8 ppm, 9.6 ppm, 11.0 ppm, and 15.7 ppm were prepared. To these seven different cleaning liquids each, ultrasonic waves were applied while a stirring unit was rotated to stir the cleaning liquid. The number of revolutions of the stirring unit was set to 1400 rpm. The frequency of the applied ultrasonic waves was set to 750 kHz and the output thereof was set to 1200 W. Whether or not foggy bubbles were generated in the cleaning liquid after the cleaning liquid was stirred was observed.

The results of the present experiment will be described with reference to Fig. 5. The state where foggy bubbles are generated in the cleaning liquid is herein referred to as Mode-A, and the state where foggy bubbles are not generated in the cleaning liquid is herein referred to as Mode-B. Mode-A is also a state of a high particle removal rate of approximately 30.0 %, and Mode-B is also a state of a low particle removal rate of approximately 18.8 %. In Mode-A, transmitted light 94 having passed through the liquid was observed by the Schlieren apparatus, and it was confirmed that a portion, which was darker than transmitted light 94 observed in the case where ultrasonic waves were not applied, appeared along the direction in which the ultrasonic waves travelled. In Mode-B, transmitted light 94 having passed through the liquid was observed by the Schlieren apparatus, and it was confirmed that a portion, which was darker than transmitted light 94 observed in the case where ultrasonic waves were not applied, failed to appear along the direction in which the ultrasonic waves travelled.

When the dissolved nitrogen concentration was 4.9 ppm or less, the foggy bubbles were not observed in the cleaning liquids (Mode-B). When the dissolved nitrogen concentration was not less than 6.0 ppm and not more than 9.6 ppm, foggy bubbles were not generated in the cleaning liquid before the cleaning liquid was stirred by the stirring unit (Mode-B). However, after the cleaning liquid was stirred by the stirring unit, foggy bubbles were generated in the cleaning liquid (Mode-A). In the case where the dissolved nitrogen concentration was not less than 11.0 ppm and not more than 15.7 ppm, foggy bubbles were generated in the cleaning liquid before and after the cleaning liquid was stirred by the stirring unit (Mode-A). From the experiment above, it is considered that the state of the cleaning liquid can be changed from Mode-B to Mode-A by stirring the cleaning liquid in the case where the dissolved nitrogen concentration of the cleaning liquid is not less than 5 ppm and not more than 11 ppm. It is also considered that Mode-A can be realized in the case where the dissolved nitrogen concentration of the cleaning liquid is 5 ppm or more.

It should be understood that the embodiment and the examples disclosed herein are illustrative and not limitative in any respect. The scope of the present invention is defined by the terms of the claims, rather than the embodiment and the examples above.

## Claims

1. An ultrasonic cleaning method for cleaning an object (W) to be cleaned in a liquid in which a gas is dissolved, by irradiating said liquid with ultrasonic waves, the method comprising the steps of:
- preparing said liquid in which said gas is dissolved; and
- cleaning said object (W) to be cleaned while irradiating said liquid with ultrasonic waves so that a region, where a spatial rate of change of a refractive index of said liquid in which said gas is dissolved is large relative to a case where ultrasonic waves are not applied, appears along a direction in which the ultrasonic waves travel.

2. The ultrasonic cleaning method according to claim 1, comprising the step of measuring the spatial rate of change of the refractive index of said liquid.

3. The ultrasonic cleaning method according to claim 2, wherein said step of measuring the spatial rate of change of the refractive index of said liquid includes the step of observing transmitted light having passed through said liquid while applying parallel rays to said liquid, in a state where ultrasonic waves are applied to said liquid.

4. The ultrasonic cleaning method according to claim 2, wherein said step of measuring the spatial rate of change of the refractive index of said liquid includes the steps of:
- observing first transmitted light having passed through said liquid while applying parallel rays to said liquid, in a state where ultrasonic waves are applied to said liquid; and
- observing second transmitted light having passed through said liquid while applying parallel rays to said liquid, in a state where ultrasonic waves are not applied to said liquid.

5. The ultrasonic cleaning method according any one of claims 2 to 4, wherein in said step of cleaning the object (W) to be cleaned, said liquid is adjusted based on said spatial rate of change so that a state where bubbles containing said gas continue to be generated in said liquid is realized.

6. The ultrasonic cleaning method according to any one of claims 1 to 5, wherein said step of cleaning the object (W) to be cleaned includes a step in which sonoluminescence occurs.

7. The ultrasonic cleaning method according to any one of claims 1 to 6, wherein said gas is nitrogen and the dissolved gas concentration of said liquid is 5 ppm or more.

8. An ultrasonic cleaning apparatus (100) for cleaning an object (W) to be cleaned in a liquid in which a gas is dissolved, by irradiating said liquid with ultrasonic waves, the apparatus comprising:
- irradiation means (30) capable of irradiating said liquid with ultrasonic waves;
a container (20) capable of containing said liquid; and
a device (71) capable of measuring a spatial rate of change of a refractive index of said liquid.

9. The ultrasonic cleaning apparatus (100) according to claim 8, comprising an adjusting mechanism (45) capable of realizing a state where bubbles containing said gas continue to be generated in said liquid, based on said spatial rate of change.
